# EUROPÄISCHE PATENTSCHRIFT

(11) **EP 2 817 829 B1**
(45) Veröffentlichungstag und Bekanntmachung des Hinweises auf die Patenterteilung: **29.11.2017**
(21) Anmeldenummer: 13707330.0
(22) Anmeldetag: 22.02.2013
(51) Int. Cl.: H01L 31/0216, H01L 31/18

(54) **VERFAHREN ZUM HERSTELLEN EINER SOLARZELLE**
METHOD FOR PRODUCING A SOLAR CELL
PROCÉDÉ DE FABRICATION D'UNE CELLULE SOLAIRE

(30) Priorität: 23.02.2012 DE 102012101456
(43) Veröffentlichungstag der Anmeldung: 31.12.2014
(73) Patentinhaber: Fraunhofer-Gesellschaft zur Förderung der angewandten Forschung e.V., 80686 München (DE)
(72) Erfinder: MOSCHNER, Jens Dirk, 63755 Alzenau (DE); NAGEL, Henning, 79104 Freiburg (DE); LACHOWICZ, Agata, 63791 Karlstein (DE); FIEDLER, Markus, 60528 Frankfurt (DE)
(86) Internationale Anmeldenummer: PCT/EP2013/053515
(87) Internationale Veröffentlichungsnummer: WO 2013/124394

(56) Entgegenhaltungen:
- EP-A1- 1 221 496
- EP-A1- 2 031 659
- EP-B1- 2 070 128
- WO-A1-99/31714
- WO-A1-2010/105585
- WO-A1-2011/080661
- WO-A2-2008/101106
- WO-A2-2011/133965
- DE-A1- 10 202 103
- DE-A1-102010 016 992
- US-A1- 2007 134 415
- US-A1- 2010 029 038
- US-A1- 2010 275 965
- US-A1- 2011 240 114

## Beschreibung

Die Erfindung bezieht sich auf ein Verfahren zum Herstellen einer Solarzelle mit einem aus Silicium bestehenden Substrat mit einer auf der Oberfläche des Substrats vorhandenen dielektrischen Passivierungsschicht in Form einer Siliciumoxidschicht und einer auf dieser aufgebrachten Antireflexionsschicht wie Siliciumnitrid- oderoxinitridschicht, die in einem Prozessraum vorzugsweise mittels PECVD-Verfahrens auf die dielektrische Passivierungsschicht abgeschieden wird.

Solarzellen aus kristallinem Silicium sind typischerweise so aufgebaut, dass ein Siliciumwafer mit einer Grunddotierung verwendet wird, in den zumindest an der für die Lichteinstrahlung bestimmten Vorderseite eine Dotierung eingebracht wird, wobei die Dotierstoffkonzentration die Grunddotierung übersteigt. Dies erfolgt durch einen der Grunddotierung entgegengesetzten Dotierungstyp, wenn die Solarzelle einen Emitter zur Ladungsträgertrennung an der Vorderseite aufweist. Wenn die Ladungsträgertrennung an der Rückseite erfolgt, wird auf der Vorderseite durch den gleichen Dotierungstyp ein sogenanntes "front surface field" gebildet. Der hochdotierte Bereich ist in der Regel relativ flach mit typischen Tiefen von wenigen Zehntel Mikrometern bis einigen Mikrometern. Diese Solarzellen weisen in der Regel eine Beschichtung der Vorderseite auf, die zur Oberflächenpassivierung dient. Diese Schicht oder eine weitere darauf aufgebrachte Schicht dienen zudem als Antireflexionsschicht.

In der Regel werden viele Solarzellen mit Hilfe von metallischen Verbindern in Reihe geschaltet und in einem Solarmodul bestehend aus mehreren Isolationsschichten einlaminiert, um sie vor Witterungseinflüssen zu schützen. Ein Problem ist, dass durch die Reihenschaltung der Solarzellen und die Reihenschaltung mehrerer Module zu einem System regelmäßig Systemspannungen von mehreren hundert Volt auftreten. Es ergeben sich hohe elektrische Felder zwischen Solarzellen und Erdpotential, die zu unerwünschten Verschiebungs- und Ableitströmen führen. Dadurch können Ladungen auf der Oberfläche der Solarzellen dauerhaft deponiert werden, die deren Wirkungsgrad erheblich reduzieren können. Auch unter Beleuchtung oder langer Lagerung im Dunkeln können sich Ladungen auf der Oberfläche anreichern.

Bekannt ist die Degradation der Leerlaufspannung und in geringerem Maß auch des Kurzschlussstroms aufgrund von Ladungen auf der Vorderseite von beidseitig kontaktierten Siliciumsolarzellen mit n-Grunddotierung und p-dotierter Vorderseite (J. Zhao, J. Schmidt, A. Wang, G. Zhang, B. S. Richards and M. A. Green, "Performance instability in n-type PERT silicon solar cells", Proceedings of the 3rd World Conference on Photovoltaic Solar Energy Conversion, 2003). Leerlaufspannung und Kurzschlussstrom degradieren stark unter Beleuchtung und langer Lagerung im Dunkeln. Als Grund für die Degradation wurde die Anreicherung von positiven Ladungen im Siliciumnitrid und/oder Siliciumoxid auf der Vorderseite identifiziert. Sie führen zur Verarmung der Siliciumoberfläche und somit zu einer Erhöhung der Oberflächenrekombinationsgeschwindigkeit für Minoritätsladungsträger. Charakteristisch ist, dass dadurch der Parallelwiderstand und somit der Füllfaktor nicht beeinträchtigt werden.

Beobachtet wurde die Degradation der Leerlaufspannung und des Kurzschlussstroms aufgrund von Ladungen auf der Vorderseite auch bei beidseitig kontaktierten Siliciumsolarzellen mit n-Grunddotierung, n-dotierter Vorderseite und p-dotierter Rückseite (J. Zhao, aaO). Sie degradieren ebenfalls stark unter Beleuchtung und langer Lagerung im Dunkeln aufgrund von Anreicherung negativer Ladungen im Siliciumnitrid und/oder Siliciumoxid auf der Vorderseite.

Die negativen Ladungen führen in diesem Fall zur Verarmung der n-dotierten Siliciumoberfläche und damit wiederum zur Erhöhung der Oberflächenrekombinationsgeschwindigkeit. Charakteristisch ist auch in diesem Fall, dass der Parallelwiderstand und somit der Füllfaktor nicht beeinträchtigt werden.

Für Module, die rückseitig kontaktierte Solarzellen mit n Grunddotierung, n-dotierter Vorderseite und lokalen p- und n-dotierten Bereichen auf der Rückseite des Substrats enthalten, ist eine Degradation aufgrund von Ladungen bekannt (siehe: R. Swanson, M. Cudzinovic, D. DeCeuster, V. Desai, J. Jürgens, N. Kaminar, W. Mulligan, L. Rodrigues-Barbosa, D. Rose, D. Smith, A. Terao and K. Wilson, "The surface polarization effect in high-efficiency silicon solar cells", Proceedings of the 15th International Photovoltaic Science & Engineering Conference, p. 410, 2005; Hans Oppermann, "Solarzelle", Patentanmeldung WO 2007/022955 sowie Philippe Welter, "Zu gute Zellen", Photon, S. 102, April 2006) Besitzen diese Module ein hohes positives Potential gegenüber Erde, so wandern negative Ladungen auf die Vorderseite der Solarzellen, an denen keine Kontakte angebracht sind. Dort können sie wegen der geringen elektrischen Leitfähigkeit des Modulverbunds auch nach Abschalten der Systemspannung über lange Zeit verbleiben. Dadurch wird die Oberflächenrekombinationsgeschwindigkeit an der Vorderseite erhöht und somit Leerlaufspannung und Kurzschlussstrom reduziert. Interessanterweise wurde auch eine Reduktion des Füllfaktors berichtet. Es tritt keine Degradation auf, wenn der positive Pol des Systems geerdet wird, d. h. wenn von vornherein nur negative Systemspannungen zugelassen werden. Offensichtlich führen positive Ladungen auf der Vorderseite dieses Solarzellentyps also nicht zu einer Degradation. Wenn eine Degradation aufgrund von negativen Ladungen auf der Vorderseite bereits stattgefunden hat, kann durch Umpolung der Systemspannung im Dunkeln bzw. über Nacht, d. h., durch Anlegen eines hohen negativen Potentials gegenüber Erde, die Degradation vorübergehend rückgängig gemacht werden (Regeneration mittels Kompensationsspannung). Dabei fließen die negativen Ladungen von der Oberfläche der Solarzellen ab. Am nächsten Tag setzt die Degradation aufgrund hoher positiver Systemspannung allerdings wieder ein, so dass die Regeneration jede Nacht erneut durchgeführt werden muss.

Ferner wurde in R. Swanson, a.a.O., zur Verhinderung der Ansammlung von Ladungen auf der Vorderseite von Solarzellen, bei denen sich alle pn-Übergänge und Metallkontakte auf der Rückseite des Substrats befinden, vorgeschlagen, einen leitenden Überzug auf die Antireflexschicht auf der Vorderseite aufzubringen und diesen Überzug mit dem Plus- oder Minuspol der Solarzellen auf der Rückseite leitend zu verbinden.

Beidseitig kontaktierte Silicium-Solarzellen mit p-Grunddotierung und n-dotierter Vorderseite sind gegenüber den oben beschriebenen Solarzellentypen wesentlich unempfindlicher auf Änderungen der Oberflächenrekombinationsgeschwindigkeit auf der Vorderseite. Deswegen wurde unter Beleuchtung und langer Lagerung im Dunkeln nur eine geringe Degradation der Leerlaufspannung festgestellt (J. Zhao, a.a.O.).

In Ines Rutschmann, "Noch nicht ausgelernt", Photon, S. 122, Januar 2008 und Ines Rutschmann, "Polarisation überwunden", Photon, S. 124, August 2008 wird beschrieben, dass Module mit beidseitig kontaktierten Silicium-Solarzellen mit p-Grunddotierung und n-dotierter Vorderseite nach dem Einwirken hoher negativer Systemspannungen niedrige Parallelwiderstände und somit auch niedrige Füllfaktoren aufweisen. Dies ist ein Zeichen für eine Wechselwirkung zwischen Emitter und Basis und ist somit grundsätzlich verschieden von den oben beschriebenen Auswirkungen auf die Oberflächenrekombinationsgeschwindigkeit. Durch Behandlung bei erhöhter Temperatur und hoher Feuchtigkeit erlangten die degradierten Module ihre Leistungsfähigkeit teilweise zurück. Bei hohen positiven Systemspannungen wurde keine Degradation festgestellt und bereits degradierte Module konnten durch Anlegen eines hohen positiven Potentials gegenüber Erde bei Dunkelheit vorübergehend regeneriert werden, d. h. eine Regeneration mittels Kompensationsspannung ist auch in diesem Fall möglich, aber mit umgekehrter Polung wie bei den oben beschriebenen Modulen, die rückseitig kontaktierte Solarzellen mit n-Grunddotierung, n-dotierter Vorderseite und lokalen p- und n-dotierten Bereichen auf der Rückseite des Substrats enthalten. Bei hohen negativen Systemspannungen setzt die Degradation wieder ein, so dass die Regeneration mittels Kompensationsspannung auch in diesem Fall regelmäßig wiederholt werden muss.

Ferner wird berichtet, dass die Degradation der Module bei hohen negativen Systemspannungen durch das verwendete Vorderseitenmetallisierungsverfahren, einem speziellen Transferdruck, verursacht wird (s. Rutschmann, a.a.O.).

Ein Test für die PID-Stabilität von Solarmodulen wird derzeit gerade etabliert. Die Testbedingungen sehen vor, an Module aus laufender Serienproduktion über sieben Tage hinweg eine Spannung von -1.000 V anzulegen. Um exakte Vergleichswerte zu erhalten, werden alle Module mit Alufolie bedeckt und bei konstant 25 Grad Celsius getestet. Ein Modul gilt dann als resistent gegen PID, wenn es in diesem Zeitraum gegenüber der Nennleistung weniger als fünf Prozent Leistung verliert.

Solarzellen aus kristallinem Silicium werden heute praktisch ausschließlich mit einer Vorderseitenbeschichtung aus Siliciumnitrid (SiN) versehen, die sowohl zur elektronischen Passivierung der Oberfläche als auch als Antireflexschicht dient. Es ist bekannt, dass mittels einer thermischen Oxidation der Oberfläche die Passivierung durch Absenkung der Grenzflächenzustandsdichte reduziert werden kann. Um diesen Effekt zu erlangen, wird die Oxidation in hochreinen Öfen nach gesonderter Reinigung der Siliciumwafer durchgeführt. Jedoch wird diese Oxidation aufgrund der damit verbundenen Kosten und Reinheitsanforderungen in der Regel nicht in industriellen Prozessen eingesetzt.

Die Abscheidung der SiN-Schicht erfolgt in der Regel mit plasmaunterstützter chemischer Gasphasenabscheidung (PECVD), da dabei auf kostengünstige Weise eine Schicht bei Temperaturen von typisch 200...500°C erzeugt werden kann, die einen einstellbaren Wasserstoffanteil enthält, der auf die Passivierwirkung der Schicht optimiert werden kann. Die Abscheidung erfolgt in der Regel im Vakuum.

Es lassen sich verschiedene Typen von Beschichtungsanlagen unterscheiden: In sogenannten Batch-Anlagen wird eine Gruppe von Wafern in eine Prozesskammer eingebracht, in der ein zeitgesteuerter Abscheideprozess abläuft, während dessen sich die Wafer in Ruhe befinden. Dabei kann die Prozesskammer zum Wechsel der Wafer belüftet werden, oder es wird eine vorgeschaltete Schleusenkammer verwendet, die wechselweise belüftet und evakuiert wird, während die Prozesskammer evakuiert bleibt. In ersterem Fall werden die Wafer durch die Heizvorrichtung der Prozesskammer auf die benötigte Temperatur geheizt. In letzterem Fall kann wahlweise dieselbe Kammer zum Ein- und Ausschleusen der Wafer verwendet werden, oder es werden zwei verschiedene Kammern eingesetzt. Das Aufheizen der Wafer erfolgt dabei in der Regel in der Schleusenkammer oder in einem zwischen Schleuse und Prozesskammer befindlichen weiteren Bereich; auch ein Aufheizen der Wafer außerhalb der Schleusenkammer ist möglich.

In sogenannten Inline-Anlagen wird dagegen der Beschichtungsprozess in einer Prozesszone im Vakuum kontinuierlich unterhalten, während Wafer - in der Regel auf Waferträgern (Carriern) - getaktet ein- und ausgeschleust werden. Bezüglich des Aufheizvorgangs gilt das Vorgenannte, jedoch entfällt die Option des Aufheizens in der Prozesszone. Gemäß dem Stand der Technik sind solche Anlagen so ausgelegt, dass die Schleusenkammern aus Durchsatzgründen sehr schnell evakuiert werden, so dass, wenn eine Aufheizung der Wafer in der Schleusenkammer erfolgt, eine Temperatur von z. B. 400°C erst dann erreicht wird, wenn der Druck und insbesondere der Sauerstoff-Partialdruck bereits sehr niedrig sind.

Vor der Abscheidung der Passivier- / Antireflexschicht werden die Siliciumsubstrate üblicherweise mehreren chemischen Prozessen unterworfen. Ein unbedingt notwendiger Schritt ist die Entfernung der oberflächlichen Glas schicht, die während der Diffusion entsteht, wie Phosphorsilikatglas oder Borsilikatglas. Hierfür wird verdünnte Flusssäure verwendet. Nach Behandlung in verdünnter Flusssäure ist die Siliciumoberfläche hydrophob. Optional kann eine chemische Kantenisolation durchgeführt werden, indem unerwünschte dotierte Bereiche mittels einer Ätzlösung, bestehend meist aus Salpetersäure und Flusssäure, entfernt werden.

Zusätzlich können Emitterätz- und Reinigungslösungen eingesetzt werden. Die ältesten bekannten Lösungen, die hier Anwendung finden, sind die Lösungen der bereits in der Halbleiterindustrie eingesetzten RCA - Reinigung. Die RCA - Reinigungssequenz beinhaltet folgende Prozessschritte: eine alkalische Lösung aus Ammoniak und Wasserstoffperoxid ("SC-1"), eine saure Lösung aus Salzsäure und Wasserstoffperoxid ("SC-2") und die Behandlung in verdünnter Flusssäure.

Gereinigte hydrophobe Substrate oxidieren langsam an der Luft (natives Oxid), innerhalb von Minuten bis Stunden und die Siliciumoberfläche wird hydrophil, die entstehende Siliciumoxidschicht hat eine Dicke von nur ca. 1 nm.

Eine gezielte und kontrollierte Hydrophilierung der Oberfläche kann ebenfalls durch chemische Oxidation erzielt werden, durch Behandlung der Substrate in Lösungen mit einem Oxidationsmittel wie Wasserstoffperoxid, Ozon oder Salpetersäure. Die so gebildeten Oxidschichten weisen eine Dicke von ca. 1,5 nm auf.

Die gemäß dem Stand der Technik hergestellten Solarzellen weisen den Nachteil auf, dass die auf der Vorderseite aufgebrachten Schichten unter Betriebsbedingungen elektrische Ladungen aufnehmen können, die die Wirkungsweise der Solarzelle beeinträchtigen und zu einem verminderten Ertrag der darauf basierenden Solarmodule führen. Dies ist insbesondere dann der Fall, wenn die Solarmodule auf hohe negative Spannungen gegen Erde gebracht werden. Die Ertragsminderung kann dabei mehr als 90 % der Leistung betragen. Dieses Phänomen ist als "Potential-induzierte Degradation" (PID) bekannt. Es zeigt sich, dass eine "natürliche" sowie chemische Oxidation der Solarzellenoberfläche vor der Antireflexbeschichtung die Degradation tendenziell reduzieren, jedoch ist es im Allgemeinen nicht möglich, sie so weit zu vermeiden, dass der Wirkungsgrad des Solarmoduls nicht beeinträchtigt wird.

Der EP-B-2 070 128, US-A-2009/0260673, WO-A-2006/096247 und US-A-2010/0307562 sind Solarzellen mit einem Siliciumwafer zu entnehmen, die oberflächlich eine dielektrische Passivierungsschicht in Form einer Oxidschicht und auf dieser eine Antireflexionsschicht aus Siliciumnitrid aufweisen, die im PECVD-Verfahren abgeschieden wird. Die dielektrische Passivierungsschicht, die eine Dicke zwischen 10 Å bis 25 Å aufweisen kann, wird entweder durch thermische Oxidation ausgebildet (EP-B-2 070 128) oder durch Eintauchen in ein Ozon enthaltendes deionisiertes Wasser (US-A-2009/0260673, WO-A-2006/096247 und US-A-2010/0307562). Dabei besteht auch die Möglichkeit, die dielektrische Passivierungsschicht nur bereichsweise unter Einsatz eines Lithografieprozesses auszubilden.

Aus der US-A-2010/0029038 ist ein Verfahren zur Herstellung einer Solarzelle bekannt, bei dem ein Solarzellensubstrat einer Prozesskammer zugeführt wird, in der ein Gasgemisch aus Argon und Sauerstoff enthalten ist und in dem ein Plasma gezündet wird. Dabei bildet sich auf dem Substrat ein Siliciumoxidfilm.

Nach der WO-A-2011/080661 wird ein Siliciumsubstrat in einem Plasma vorbehandelt, wobei das Substrat oxidiert.

Die Herstellung einer Solarzelle ist Gegenstand der US-A-2011/0240114. Dabei wird das Substrat einem Plasma ausgesetzt, in dem ein Precursor-Gas enthalten ist, um eine Siliciumoxidschicht auszubilden.

Um eine SiO₂-Schicht auf einem Solarzellensubstrat auszubilden, ist nach der US-A-2010/0275965 eine thermische Oxidation vorgesehen.

In der EP-A-2 031 659 wird ein Inline-Verfahren zur Herstellung von Druckkontakten von Solarzellen beschrieben.

Aus der WO-A-99/31714 erfolgt ein Vorprozessieren eines Wafers in einer Schleusenkammer.

Der vorliegenden Erfindung liegt die Aufgabe zu Grunde, ein Verfahren der eingangs genannten Art so weiterzubilden, dass eine Stabilität der Solarzellen bzw. der daraus gefertigten Solarzellenmodule gegen eine potential induzierte Degradation (PID) gegeben ist. Dabei soll das Verfahren ohne wesentliche Änderungen in die industrielle Fertigung implementiert werden können, ohne dass es zu einer hohen Kostenbelastung führt. Zusätzliche Anlagen, insbesondere Prozessräume, sollen nicht erforderlich sein.

Zur Lösung der Aufgabe sieht die Erfindung im Wesentlichen vor, dass die dielektrische Passivierungsschicht aus der Oberfläche des Substrats in dem Prozessraum mittels eines zumindest teilweise dissoziierten, oxidierenden Gases, insbesondere mittels eines ein oxidierendes Gas enthaltenden Plasmas ausgebildet wird oder dass die dielektrische Passivierungsschicht aus der Oberfläche des Substrats in einem dem Prozessraum vorgeschalteten Vorprozessraum in Gegenwart eines oxidierenden Gases ausgebildet wird, wobei das Substrat in dem Vorprozessraum einer Temperatur T mit T ≥ 250 °C, über eine Zeit t bei einem Sauerstoffpartialdruck von zumindest 1kPa ausgesetzt wird, wobei vor Herstellen der dielektrischen Passivierungsschicht die Oberfläche des Substrats mit hydrophilen Eigenschaften versehen wird und zur Erzeugung der hydrophilen Eigenschaften eine alkalische oder saure Lösung mit einem Oxidationsmittel benutzt wird.

Der Begriff Plasma wird nachfolgend zusammenfassend für ein zumindest teilweise dissoziiertes, oxidierendes Gas sowie ein das oxidierende Gas enthaltendes Plasma verwendet.

Erfindungsgemäß kann eine Stabilität gegen eine potential induzierte Degradation dadurch erzielt werden, dass aus der Oberfläche des Siliciumsubstrats im Plasma die Siliciumoxidschicht ausgebildet wird. Somit können die Komponenten einer Batch-Anlage ohne Veränderungen benutzt werden, mit der die erforderliche Antireflexionsschicht abgeschieden wird. Es erfolgt eine gezielte Oxidation im Plasma, wodurch definierte Schichtdicken der dielektrischen Passivierungsschicht, also der Siliciumoxidschicht, erzielbar sind. Hierzu wird in dem Prozessraum gezielt ein oxidierendes Gas eingeleitet.

Die Erfindung wird jedoch auch dann nicht verlassen, wenn das oxidierende Gas zusätzlich Silan enthält. Hierdurch scheidet sich auf der Oberfläche des Substrats eine Siliciumoxidschicht ab.

Es besteht jedoch auch die Möglichkeit einer gezielten thermischen Oxidation, die in einer bestehenden Inline-Anlagen durchführbar ist, wobei durch gezielte Prozesssteuerung im Vorprozessraum, bei dem es sich um den Schleusenraum bzw. die Schleusenkammer handeln kann, die dem Prozessraum vorgeschaltet ist, die gewünschte Dicke der dielektrischen Passivierungsschicht aus der Oberfläche ausgebildet werden kann.

Die dielektrische Passivierungsschicht wird vorzugsweise im Wesentlichen aus der Oberfläche des Substrates ausgebildet. Es handelt sich hierbei somit im Wesentlichen um eine sogenannte "gewachsene" Schicht - im Gegensatz zu einer abgeschiedenen Schicht. Insbesondere ist es vorteilhaft, die dielektrische Passivierungsschicht ausschließlich aus der Oberfläche des Substrates auszubilden.

Die dielektrische Passivierungsschicht weist bevorzugt eine Dicke D größer 0,3 nm, insbesondere größer 0,5 nm auf, um eine ausreichende Stabilität gegenüber PID zu gewährleisten. Um keine weiteren Eigenschaften der Solarzelle zu beeinträchtigen weist die dielektrische Passivierungsschicht vorzugsweise eine Dicke D kleiner 125 nm, bevorzugt kleiner 25 nm, insbesondere bevorzugt kleiner 3 nm auf.

Insbesondere ist vorteilhaft, dass die Siliciumoxidschicht eine Dicke D mit 0,5 nm ≤ D ≤ 3 nm aufweist.

Gegenstand der Erfindung ist folglich die Weiterbildung bekannter Verfahren zur Herstellung von Siliciumsolarzellen derart, dass die Grenzfläche zwischen dotierten Bereichen und der Antireflexionsbeschichtung derart modifiziert wird, dass eine Stabilität der Solarzelle gegen potential-induzierte Degradation (PID) erreicht wird, wobei der apparative Aufwand minimiert wird. Bei PID handelt es sich um eine Degradation der Leistung der Solarzelle, die auftritt, wenn diese in einem System einer hohen Spannung gegen Erdpotential ausgesetzt wird.

Bei den bekannten Anlagen wird das zu prozessierende Substrat auf einem Träger angeordnet und sodann dem Prozessraum zugeführt. Erfindungsgemäß ist in Weiterbildung vorgesehen, dass das Substrat auf dem Träger in dem Vorprozessraum, insbesondere in dem Schleusenraum aufgeheizt und einer oxidierenden Atmosphäre ausgesetzt wird. Dabei wird als oxidierende Atmosphäre bzw. oxidierendes Gas vorzugsweise eine solche bzw. ein solches verwendet, bei der bzw. dem der Sauerstoffpartialdruck zumindest 100 Pa, vorzugsweise zumindest 1 kPa, vorzugsweise zumindest 5 kPa beträgt.

Als oxidierendes Gas kann Sauerstoff, Distickstoffmonoxid, Ozon oder Mischungen dieser eingesetzt werden. Ferner besteht erwähntermaßen die Möglichkeit, dem oxidierenden Gas Silan zuzusetzen, so dass sich eine Siliciumoxidschicht abscheidet.

Bei Ausbildung der dielektrischen Passivierungsschicht aus der Oberfläche des Substrats in dem dem Prozessraum vorgeschalteten Vorprozessraum ist es insbesondere vorteilhaft, dass das Substrat in dem Vorprozessraum einer Temperatur T mit T ≥ 300 °C, weiter bevorzugt T ≥ 350 °C, insbesondere T ≥ 400 °C ausgesetzt wird.

Insbesondere ist vorteilhaft, dass das Substrat, also der Wafer, in dem Vorprozessraum, wie Schleusenraum, auf eine Temperatur von zumindest 400 °C, insbesondere zwischen 400 °C und 800 °C aufgeheizt wird und über eine Zeit t der oxidierenden Atmosphäre bzw. dem oxidierenden Gas ausgesetzt wird. Dabei sollte die Zeitdauer zwischen 2 s und 60 s liegen.

Erfindungsgemäß wird vorgeschlagen, dass auf dem Siliciumsubstrat vor Ausbildung der dielektrischen Passivierungsschicht, also der Oxidschicht, insbesondere Siliciumoxidschicht, eine hydrophile Oberfläche ausgebildet wird. Hierzu wird das Substrat mit einer alkalischen oder sauren Lösung mit einem Oxidationsmittel behandelt. Als alkalische Komponente der alkalischen Lösung kommt zumindest eine Komponente aus der Gruppe NaOH, KOH, Tetraalkylammoniumhydroxid wie Tetramethylammoniumhydroxid in Frage. Für die saure Lösung ist Methansulfonsäure zu bevorzugen. Als Oxidationsbildner ist bevorzugterweise ein Element aus der Gruppe Percarbonate, Perborate, Peroxomonosulfate, Peroxodisulfate, Hypochlorit vorgesehen.

Unabhängig hiervon besteht die Möglichkeit, dass die alkalische Lösung neben dem Oxidationsmittel weitere Komponenten wie Stabilisatoren, Komplexbildner oder Tenside enthält.

Erfindungsgemäß wird zur Herstellung einer PID-stabilen Solarzelle die Ausbildung bzw. das Aufbringen einer Dünnoxidschicht auf der Solarzellenvorderseite vor der Abscheidung der Antireflexionsschicht vorgeschlagen. Dabei wird als Oxidschicht die Ausbildung bzw. das Aufbringen einer Dünnoxidschicht auf der Solarzellenvorderseite vor der Abscheidung der Antireflexionsschicht vorgeschlagen. Dabei sollte die Dicke der Oxidschicht, also die dielektrische Passivierungsschicht eine Dicke zwischen 0,5 nm und 3 nm betragen. Abhängig vom gewählten Beschichtungsverfahren für die Antireflexionsschicht kann die Schicht in unterschiedlicher Weise aufgebracht werden, ohne dass es dem Grunde nach konstruktiver Änderungen der Anlage zum Abscheiden der Antireflexionsschicht bedarf.

Wird die Beschichtung der Solarzellenvorderseite in einer Batch-Anlage durchgeführt, so wird die Oxidation durch kurzzeitiges Zünden eines Plasmas in einer Atmosphäre von einem Oxidationsmittel wie Distickstoffmonoxid oder Sauerstoff durchgeführt. Alternativ kann die Abscheidung einer Siliciumoxidschicht durch ein Plasma eines Gasgemisches von Silan und einem Oxidationsmittel erfolgen.

Diese Prozesse können mit geringem zusätzlichen Zeitaufwand in einer Beschichtungsanlage durchgeführt werden, die dem industriellen Standard entspricht.

Erfolgt die Beschichtung in einer sogenannten Inline-Anlage, bei der der Transport der Wafer über Schleusen in einen permanent evakuierten Prozessbereich erfolgt, so erfolgt die Oxidation der Wafer durch Aufheizen an Luft oder in einer anderen sauerstoffhaltigen Atmosphäre vor der Abscheidung der Antireflexschicht. Vorzugsweise werden die Wafer, wenn sie auf einem Waferträger zum Transport in der Anlage platziert sind, aufgeheizt, während sie sich noch an Luft befinden. Es kann ebenfalls die Evakuierungsphase der Schleusenkammer genutzt werden, während derer sich noch ein Restluftdruck in der Kammer befindet. Dabei werden die Wafer vor oder während des Schleusvorgangs aufgeheizt; vorteilhafterweise wird hierzu die Schleusenkammer mit Luft oder einem Stickstoff/Sauerstoff-Gemisch belüftet. Die Temperatur während der Oxidation muss bzw. sollte oberhalb von 250 °C liegen. Um den Durchsatz der Anlage durch den Zeitbedarf der Oxidation nicht zu reduzieren, bietet es sich an, den Einschleusvorgang zweistufig auszuführen, so dass die erste, äußere Schleuse, in der die Oxidation erfolgt, nicht auf den niedrigen Beschichtungsdruck evakuiert werden muss, sondern nur bis zu einem höheren Transferdruck. In einer inneren Schleuse wird dann bis auf den benötigten Basisdruck evakuiert, bevor der Waferträger in die Prozesskammer transferiert wird.

Es besteht jedoch auch die Möglichkeit, bei zum Einsatz gelangenden Anlagen, bei denen vor Einbringen der Substrate in den Prozessraum, in dem mittels PECVD-Verfahren die Antireflexionsschicht abgeschieden wird, in dem dem Prozessorraum vorgeschalteten Schleusenraum das Ausbilden des Vakuums, also Abpumpen der Luft zeitverzögert durchzuführen, so dass das Substrat in der erforderlichen Zeit einer Sauerstoff enthaltenden Atmosphäre bei einer Temperatur T mit T ≥ 250 °C ausgesetzt werden kann, um die gewünschte Oxidschicht als die dielektrische Pas sivierungs schicht auszubilden, wobei die Parameter derart aufeinander abgestimmt sein sollten, dass die Oxidschicht eine Dicke größer 0,3 nm, bevorzugt zwischen 0,5 nm und 3 nm aufweist.

Kommt eine Beschichtungsanlage zum Einsatz, in der ein Batch-Prozess mit separaten Schleusen kombiniert ist, so können beide Verfahren kombiniert werden. Dabei erfolgt das Einschleusen in der Regel einstufig.

Durch eine hinreichend starke Oxidation der Oberfläche kann mit dem erfindungsgemäß beschriebenen Verfahren die Stabilität der hergestellten Solarzellen gegen PID erreicht werden. Die Oxidationsparameter lassen sich dabei so anpassen, dass eine ggf. beobachtete Rest-Degradation den Wirkungsgrad des Solarmoduls nicht beeinträchtigt. Es werden keine zusätzlichen Anlagen zur Oxidation benötigt, indem der Siliciumwafer auf dem für die Oberflächenbeschichtung ohnehin erforderlichen Werkstückträger (Carrier, Palette, Boot etc.) der Oxidation unterzogen wird. Es zeigt sich, dass nicht nur die Schichtdicke, sondern insbesondere die Parameter der Schichtherstellung für die PID-Stabilität ausschlaggebend sind.

Bei Ausbilden der dielektrischen Passivierungsschicht aus der Oberfläche des Substrats in dem Prozessraum mittels eines zumindest teilweise dissoziierten, oxidierenden Gases, vorzugsweise mittels eines ein oxidierendes Gas enthaltenden Plasmas erfolgt bevorzugt die Ausbildung der auf der dielektrischen Passivierungsschicht aufgebrachten Schicht in demselben Prozessraum.

Die auf der dielektrischen Passivierungsschicht aufgebrachte Schicht ist als Antireflexschicht ausgebildet.

Die auf der dielektrischen Passivierungsschicht aufgebrachte Schicht ist vorzugsweise als eine Schicht aus der Gruppe Siliziumnitridschicht, Siliciumoxinitridschicht, Siliziumoxidschicht, Aluminiumoxidschicht, Aluminiumnitridschicht, Titanoxidschicht, insbesondere bevorzugt als Schichtsystem umfassend mindesten zwei Schichten, vorzugsweise umfassend mindestens eine der vorgenannten Schichten, ausgebildet.

Vorzugsweise wird die auf der Siliziumoxidschicht aufgebrachte Schicht Wasserstoff enthaltend ausgebildet.

Vorzugsweise wird die auf der Siliziumoxidschicht aufgebrachte Schicht mittels eines PECVD-Verfahrens abgeschieden.

Bei Ausbildung der auf der dielektrischen Passivierungsschicht aufgebrachten Schicht in demselben Prozessraum des Ausbildens der dielektrischen Passivierungsschicht wird vorzugsweise die auf der dielektrischen Passivierungsschicht aufgebrachte Schicht als eine Schicht aus der Gruppe Siliziumnitridschicht, Siliciumoxinitridschicht, Aluminiumoxidschicht, Aluminiumnitridschicht, Titanoxidschicht oder Titanschicht ausgebildet, insbesondere bevorzugt mittels PECVD.

Bei Ausbildung der dielektrischen Passivierungsschicht aus der Oberfläche des Substrats in einem dem Prozessraum vorgeschalteten Vorprozessraum ist es insbesondere vorteilhaft, die auf der dielektrischen Passivierungsschicht aufgebrachte Schicht als eine Schicht aus der Gruppe Siliziumnitridschicht, Siliciumoxinitridschicht, Aluminiumoxidschicht, Aluminiumnitridschicht oder Titanschicht auszubilden, bevorzugt mittels eines CVD-Verfahrens.

Weitere Einzelheiten, Vorteile und Merkmale der Erfindung ergeben sich nicht nur aus den Ansprüchen, den diesen zu entnehmenden Merkmalen - für sich und/oder in Kombination-, sondern auch aus der nachfolgenden Beschreibung von bevorzugten Ausführungsbeispielen.

Es zeigen:
- Fig. 1: eine Prinzipdarstellung eines Batch-PECDV-Reaktors und
- Fig. 2: eine Prinzipdarstellung einer Inline-PECVD-Anlage und
- Fig. 3: einen Temperatur-Sauerstoffpartialdruckverlauf in einer Vorprozesskammer.

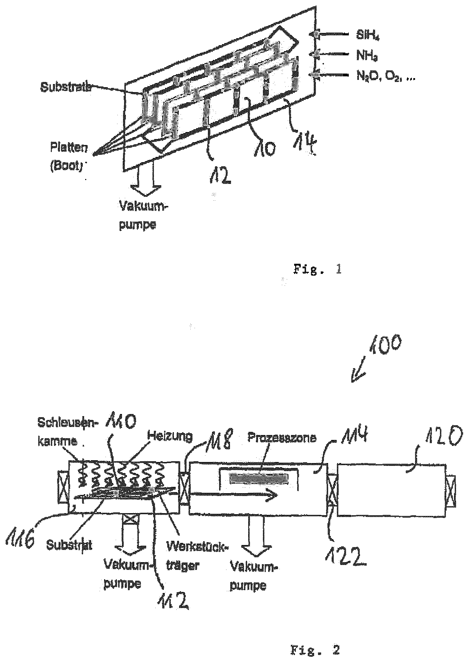

Anhand der Figuren soll prinzipiell verdeutlicht werden, dass die erfindungsgemäße kontrollierte Ausbildung einer dielektrischen Passivierungsschicht auf der frontseitig verlaufenden Oberfläche eines Siliciumsubstrats 10 in einer Beschichtungsanlage 14 erfolgen kann, bei der es sich nach dem Stand der Technik um einen Batch-PECVD-Reaktor handeln kann, in dem üblicherweise auf der Frontseite eines Siliciumwafers eine Antireflexionsschicht abgeschieden wird. Hierzu wird in gewohnter Weise ein sogenanntes Boot eingesetzt, das aus einer Anzahl paralleler Platten als Träger 12 besteht, die wechselweise elektrisch verbunden sind und die als Elektroden zur Plasmaerzeugung in der PECVD-Anlage verwendet werden. Die Siliciumsubstrate 10 werden auf diesen Platten platziert und mit der Plattenanordnung in die Beschichtungsanlage verbracht (Fig. 1). Dabei liegt die bei der fertigen Solarzelle die Rückseite bildende Fläche auf dem Träger bzw. den Platten 12, so dass diese beim durchzuführenden Plasmaprozess abgedeckt sind.

Nach Beschicken des Prozessraums 14 mit den Trägern 12 und Evakuieren des Prozessraums 14 wird ein oxidierendes Gas gezündet. Das zu zündende oxidierende Gas kann Sauerstoff, Distickstoffmonoxid, Ozon oder Mischungen dieser enthalten.

Durch das so erzeugte das oxidierende Gas enthaltende Plasma bildet sich aus der Oberfläche der Substrate 10 eine Siliciumoxidschicht aus, über die eine Stabilität der fertigen Solarzelle gegen potential induzierte Degradation erzielbar ist.

Gegebenenfalls kann das oxidierende Gas Silan enthalten, so dass neben dem Ausbilden der dielektrischen Passivierungsschicht aus der Oberfläche auch ein Abscheiden einer Siliciumoxidschicht erfolgt.

Anschließend wird die Gasatmosphäre gewechselt, um die Substrate 10 einem Plasma auszusetzen, um die gewünschte Antireflexionsschicht wie Siliciumnitrid- oder -oxinitridschicht abzuscheiden. Hierzu wird SiH₄ oder NH₃ dem Prozessraum 14 zugeführt, wie dies durch die Pfeile in Fig. 1 symbolisiert wird.

Mit anderen Worten wird eine Beschichtungsanlage benutzt, die zumindest einen beheizten evakuierbaren Prozessraum 14 umfasst, in der der Beschichtungsprozess durchgeführt wird. Die Plattenordnung mit den darauf befindlichen Substraten 10 wird zunächst aufgeheizt; gleichzeitig oder später wird der Prozessraum 14 evakuiert. Entsprechend dem Stand der Technik kann zunächst ein Plasma mit Oxid reduzierenden oder chemisch neutralen Gasen gezündet werden, um die Substratoberfläche zu konditionieren. Gemäß der Erfindung wird sodann ein oxidierendes Gas oder Gasgemisch in den Prozessraum 14 eingeleitet und ein Plasma gezündet. Hierdurch wird eine Siliciumoxid-Schicht an der Oberfläche der Substrate 10 ausgebildet.

Es besteht auch die Möglichkeit, dass dem oxidierenden Gas Silan beigemischt wird, so dass eine Siliciumoxid-Schicht aus der Gasphase abgeschieden wird.

Erkennbar wird der Anlagenaufbau einer Anlage zum Herstellen von Solarzellen nicht geändert, da der für das Abscheiden der Antireflexionsschicht benutzte Prozessraum 14, der auch als Reaktor zu bezeichnen ist, auch für das Ausbilden bzw. Abscheiden der dielektrischen Passivierungsschicht in Form der Siliciumoxidschicht benutzt wird. Dabei schließt der Begriff Siliciumoxidschicht auch eine dielektrische Passivierungsschicht ein, die Siliciumoxid enthält.

In Fig. 2 ist rein prinzipiell eine Inline-PECVD-Anlage 100 dargestellt, wie diese bei der Herstellung von Solarzellen eingesetzt wird. Dem Prozessraum 114 ist eine als Vorprozessraum zu bezeichnende Schleusenkammer 116 vorgeschaltet, die nach Einbringen von auf einem Träger 112 mit ihren Rückseiten platzierten Substraten 110 evakuiert werden muss, um dem unter Vakuum stehenden Prozessraum 114 den Träger 112 mit den Substraten 110 zuführen zu können.

Erfindungsgemäß ist vorgesehen, dass vor dem Evakuieren der Schleusenkammer 116, also dem Vorprozessraum, erfindungsgemäß durch thermische Oxidation eine dielektrische Passivierungsschicht aus der Oberfläche der Substrate 110 ausgebildet wird, also eine Siliciumoxidschicht erzeugt wird. Hierzu werden die Substrate 110 in dem Vorprozessraum auf eine Temperatur T von zumindest 400 °C aufgeheizt, um sodann in einer oxidierenden Atmosphäre wie Luft bzw. oxidierendem Gas, das Sauerstoff, Distickstoffmonoxid, Ozon oder Mischungen dieser enthalten kann, über eine Zeit t von zumindest 2 s ausgesetzt zu werden. Der Zeitraum sollte dabei 60 s nicht überschreiten. Während dieser Zeit bildet sich durch thermische Oxidation aus der frontseitigen Oberfläche der Substrate 110 die gewünschte dielektrische Passivierungsschicht aus.

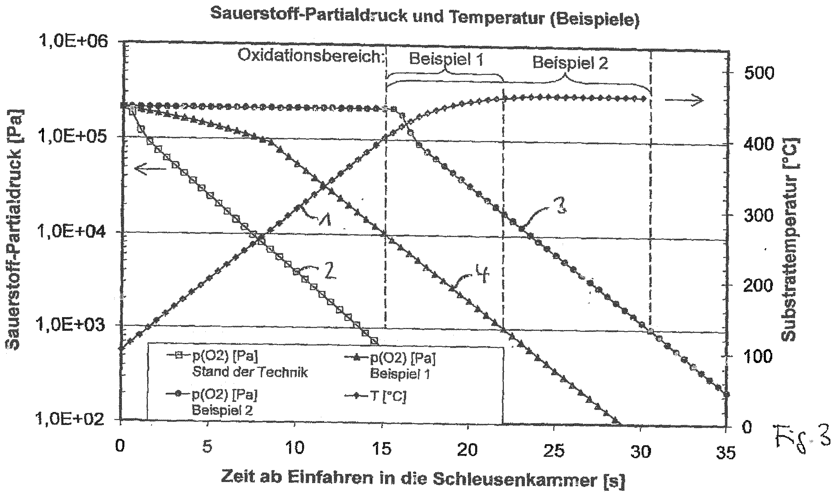

Es werden folglich Siliciumsubstrate 110 auf einem planaren Werkstückträger 112 platziert, der zum Transport der Substrate 110 durch eine Beschichtungsanlage 100 dient. Der Werkstückträger 112 wird in die Schleusenkammer 116 der Beschichtungsanlage 100 transportiert, in der der Werkstückträger 112 und die Substrate 110 beheizt werden. Dabei kann der Evakuierungsvorgang in der Schleusenkammer, also dem Vorprozessraum 116 gestartet werden, nachdem die Substrattemperatur einen Wert von 400 °C überschritten hat (Beispiel 1 in Fig. 3), oder der Evakuierungsvorgang erfolgt so langsam, dass diese Temperatur erreicht wird, während der Sauerstoff-Partialdruck noch so hoch ist, das eine Oxidation der Substratoberfläche bewirkt wird, also z. B. höher als 1 kPa (Beispiel 2 in Fig. 3). Dadurch wird ein Sauerstoff-Partialdruck von mehr als 1 kPa bei einer Substrattemperatur von mehr als 400 °C über eine Zeit von mehreren Sekunden aufrechterhalten.

Die entsprechenden Verhältnisse sind der Fig. 3 zu entnehmen. So ist mit der Kurve 1 der Temperaturverlauf in dem Vorprozessraum 116 dargestellt, in dem nach Einbringen der Substrate 110 auf dem Werkstückträger 112 das Substrat 110 auf eine Temperatur von über 400 °C aufgeheizt wird. Nach dem Stand der Technik erfolgt gleichzeitig ein Evakuieren des Vorprozessraums. Dies wird durch die Kurve 2 symbolisiert.

Man erkennt, dass dann, wenn die Temperatur im Vorprozessraum 400 °C beträgt, der Sauerstoffpartialdruck kleiner als 1 kPa ist, also einen Wert aufweist, der zu einer definierten thermischen Ausbildung einer Siliciumoxidschicht nicht ausreicht, um eine Siliciumoxidschicht einer Dicke zwischen 0,5 nm und 3 nm auszubilden, um somit eine Stabilität einer aus dem Substrat hergestellten Solarzelle gegen eine potential induzierte Degradation zu erreichen.

Erfolgt demgegenüber entsprechend der erfindungsgemäßen Lehre eine Evakuierung des Vorprozessraums 116 erst dann, wenn die gewünschte Temperatur zur thermischen Oxidation erreicht ist, so ist sichergestellt, dass das Substrat über die erforderliche Zeit von zumindest 2 s einer oxidierenden Atmosphäre ausgesetzt ist, durch die die Siliciumoxidschicht gewünschter Dicke ausbildbar ist. Dies wird durch die Kurve 3 verdeutlicht. Es besteht jedoch auch die Möglichkeit, dass der Evakuierungsvorgang verzögert oder so langsam durchgeführt wird, dass das Substrat 110 in dem Vorprozessraum 116 der erforderlichen Zeit und der notwendigen Temperatur einer oxidierenden Atmosphäre ausgesetzt wird, bei der der Sauerstoffpartialdruck mehr als 1 kPa, vorzugsweise mehr als 5 kPa beträgt, so dass die Siliciumoxidschicht aus der Oberfläche des Siliciumsubstrats 110 ausgebildet werden kann. Dies wird durch die Kurve 4 verdeutlicht.

Nach dem Evakuieren wird der Träger 112 mit den Substraten 110 dem Prozessraum 114 über eine Schleuse 118 zugeführt. Nachdem in dem Prozessraum 114 in gewohnter Weise durch PECVD-Verfahren eine Antireflexionsschicht abgeschieden worden ist, wird der Träger 112 einer dem Prozessraum 114 nachgeordneten Schleusenkammer nach Passieren einer weiteren Schleuse 122 übergeben. Insoweit wird auf hinlänglich bekannte Inline-PECVD-Anlagen verwiesen, ohne dass es näherer Erläuterungen bedarf.

## Patentansprüche

1. Verfahren zum Herstellen einer Solarzelle mit einem aus Silicium bestehenden Substrat mit einer auf der Oberfläche des Substrats vorhandenen dielektrischen Passivierungsschicht in Form einer Siliciumoxidschicht und einer auf dieser aufgebrachten Antireflexionsschicht, die in einem Prozessraum vorzugsweise mittels PECVD-Verfahrens auf die dielektrische Passivierungsschicht abgeschieden wird,
**dadurch gekennzeichnet,**
**dass** die dielektrische Passivierungsschicht aus der Oberfläche des Substrats in dem Prozessraum mittels eines zumindest teilweise dissoziierten, oxidierenden Gases, wie mittels eines ein oxidierendes Gas enthaltenden Plasmas, ausgebildet wird oder dass die dielektrische Passivierungsschicht aus der Oberfläche des Substrats in einem dem Prozessraum vorgeschalteten Vorprozessraum in Gegenwart eines oxidierenden Gases ausgebildet wird, wobei das Substrat in dem Vorprozessraum einer Temperatur T mit T ≥ 250 °C, über eine Zeit t bei einem Sauerstoffpartialdruck von zumindest 1kPa ausgesetzt wird, wobei vor Herstellen der dielektrischen Passivierungsschicht die Oberfläche des Substrats mit hydrophilen Eigenschaften versehen wird und zur Erzeugung der hydrophilen Eigenschaften eine alkalische oder saure Lösung mit einem Oxidationsmittel benutzt wird.

2. Verfahren nach Anspruch 1,
**dadurch gekennzeichnet,**
**dass** als das Plasma ein solches verwendet wird, das zusätzlich Silan enthält.

3. Verfahren nach Anspruch 1 oder 2,
**dadurch gekennzeichnet,**
**dass** die Ausbildung der dielektrischen Passivierungsschicht in einem dem Prozessraum vorgeschalteten Schleusenraum als dem Vorprozessraum durchgeführt wird.

4. Verfahren nach zumindest einem der vorhergehenden Ansprüche,
**dadurch gekennzeichnet,**
**dass** der Sauerstoffpartialdruck in dem oxidierenden Gas auf zumindest 5 kPa eingestellt wird.

5. Verfahren nach zumindest einem der vorhergehenden Ansprüche, wobei das Substrat auf einem Träger angeordnet dem Prozessraum zugeführt wird,
**dadurch gekennzeichnet,**
**dass** das Substrat in dem Vorprozessraum auf dem Träger angeordnet bei der Temperatur T mit 250 °C ≤ T ≤ 800 °C, insbesondere 400 °C ≤ T ≤ 800 °C, dem oxidierenden Gas wie Luft über die Zeit t mit t > 1 s, bevorzugt t > 2 s, insbesondere 2 s ≤ t ≤ 60 s ausgesetzt wird.

6. Verfahren nach zumindest Anspruch 1,
**dadurch gekennzeichnet,**
**dass** als oxidierendes Gas zumindest ein Gas aus der Gruppe Sauerstoff, Distickstoffmonoxid, Ozon oder Mischungen dieser verwendet wird.

7. Verfahren nach zumindest Anspruch 1,
**dadurch gekennzeichnet,**
**dass** als Komponenten der alkalischen Lösung zumindest eine Komponente aus der Gruppe NaOH, KOH, Tetraalkylammoniumhydroxid wie Tetramethylammoniumhydroxid und/oder für die saure Lösung Methansulfonsäure verwendet wird.

8. Verfahren nach zumindest Anspruch 1,
**dadurch gekennzeichnet,**
**dass** als Oxidationsmittel zumindest ein Mittel aus der Gruppe Percarbonate, Perborate, Peroxomonosulfate, Peroxodisulfate, Hypochlorit verwendet wird.

9. Verfahren nach zumindest Anspruch 1,
**dadurch gekennzeichnet,**
**dass** dem Oxidationsmittel zumindest eine weitere Komponente aus der Gruppe Stabilisatoren, Komplexbildner, Tenside zugesetzt wird.

10. Verfahren nach zumindest einem der vorhergehenden Ansprüche,
**dadurch gekennzeichnet,**
**dass** das Substrat in dem Vorprozessraum einer Temperatur T mit T ≥ 300 °C, bevorzugt T ≥ 350 °C, insbesondere T ≥ 400 °C ausgesetzt wird.

11. Verfahren nach zumindest einem der vorhergehenden Ansprüche,
**dadurch gekennzeichnet,**
**dass** die auf der Siliziumoxidschicht aufgebrachte Schicht Wasserstoff enthaltend ausgebildet wird.

12. Verfahren nach zumindest einem der vorhergehenden Ansprüche,
**dadurch gekennzeichnet,**
**dass** die auf der Siliziumoxidschicht aufgebrachte Schicht zumindest als eine der Schichten Siliziumnitridschicht, wie Siliciumoxinitridschicht, Siliziumoxidschicht, Aluminiumoxidschicht, Aluminiumnitridschicht, Titanoxidschicht, insbesondere als Schichtsystem umfassend mindestens zwei Schichten ausgebildet wird.

## Claims

1. Method for manufacturing a solar cell having a substrate consisting of silicon with a dielectric passivation layer in the form of a silicon oxide layer provided on the surface of said substrate and with an antireflective layer applied thereon which is deposited onto said dielectric passivation layer preferably by means of the PECVD method in a process room,
**characterized in**
the dielectric passivation layer is formed out of the surface of the substrate in the process room by means of an at least partly dissociated oxidizing gas, such as by means of a plasma containing an oxidizing gas, or said dielectric passivation layer is formed out of said surface of said substrate in a pre-process room upstream of said process room in the presence of an oxidizing gas, where said substrate is subjected in said pre-process room to a temperature T of T ≥ 250 °C over a time t with an oxygen partial pressure of at least 1 kPa and where before manufacture of said dielectric passivation layer said surface of said substrate is provided with hydrophilic properties and an alkaline or acid solution with an oxidizing agent is used to generate said hydrophilic properties.

2. Method according to claim 1,
**characterized in**
the plasma used is one additionally containing silane.

3. Method according to claim 1 or 2,
**characterized in**
**that** the formation of the dielectric passivation layer is carried out in an airlock space, as preliminary processing space, upstream of the processing space.

4. Method according to at least one of the preceding claims,
**characterized in**
**that** the oxygen partial pressure in the oxidizing gas is adjusted to at least 5 kPa.

5. Method according to at least one of the preceding claims, wherein the substrate arranged on a carrier is fed to the processing space,
**characterized in**
**that** the substrate arranged on the carrier is exposed to the oxidizing gas such as air in the preliminary processing space at the temperature T where 250 °C ≤ T ≤ 800 °C, preferably 400 °C ≤ T ≤ 800 °C, for time t where t > 1 s, preferably t > 2 s, in particular 2 s ≤ t ≤ 60 s.

6. Method according to at least claim 1,
**characterized in**
**that**, as oxidizing gas, at least one gas from the group of oxygen, dinitrogen monoxide or mixtures thereof is used.

7. Method according to at least claim 1,
**characterized in**
**that**, as components of the alkaline solution, at least one component from the group of NaOH, KOH, tetraalkylammonium hydroxide such as tetramethylammonium hydroxide and/or for the acidic solution, methanesulfonic acid is used.

8. Method according to at least claim 1,
**characterized in**
**that**, as oxidation agent, at least one agent from the group of percarbonates, perborates, peroxomonosulfates, peroxodisulfates, hypochlorite is used.

9. Method according to at least claim 1,
**characterized in**
**that** an additional component from the group of stabilizers, complexing agents, surfactants is added to the oxidation agent.

10. Method according to at least one of the preceding claims,
**characterized in**
**that** the substrate is exposed in the preliminary processing space at a temperature T with T ≥ 300 °C, preferably T ≥ 350 °C, in particular T ≥ 400 °C.

11. Method according to at least one of the preceding claims,
**characterized in**
**that** the layer applied to the silicon oxide layer is formed so that it contains hydrogen.

12. Method according to at least one of the preceding claims,
**characterized in**
**that** the layer applied to the silicon oxide layer is formed as at least one of the layers silicon dinitride layer, such as silicon oxinitride layer, silicon oxide layer, aluminum oxide layer, aluminum nitride layer, titanium oxide layer, in particular as a layer system comprising at least two layers.

## Revendications

1. Procédé pour fabriquer une cellule solaire avec un substrat constitué de silicium avec une couche de passivation diélectrique sur la surface dudit substrat, sous forme de couche d'oxyde de silicium, et avec une couche antireflet appliquée sur celle-ci, laquelle couche antireflet est déposée sur la couche de passivation diélectrique dans une chambre de traitement, de préférence au moyen d'un procédé PECVD,
**caractérisé en ce**
**que** la couche de passivation diélectrique est formée à partir de la surface du substrat dans la chambre de traitement, au moyen d'un gaz oxydant au moins dissocié en partie, tel un plasma contenant un gaz oxydant ou que la couche de passivation diélectrique est formée à partir de la surface du substrat dans une chambre de prétraitement en amont de la chambre de traitement en présence d'un gaz oxydant, sachant que le substrat est exposé dans ladite chambre de prétraitement à une température T avec T ≥ 250 °C pendant une durée t sous une pression partielle d'oxygène d'au moins 1 kPa, sachant qu'avant la fabrication de la couche de passivation diélectrique, la surface du substrat est dotée de caractéristiques hydrophiles et qu'une solution alcaline ou acide est utilisée avec un agent oxydant pour créer lesdites caractéristiques hydrophiles.

2. Procédé selon la revendication 1,
**caractérisé en ce**
**qu'**est utilisé comme plasma un plasma contenant en plus du silane.

3. Procédé selon la revendication 1 ou 2,
**caractérisé en ce**
**que** la formation de la couche de passivation diélectrique est réalisée dans un sas situé en amont de la chambre de traitement et servant de chambre de prétraitement.

4. Procédé selon au moins une des revendications précédentes,
**caractérisé en ce**
**que** la pression partielle d'oxygène dans le gaz oxydant est réglée sur au moins 5 kPa.

5. Procédé selon au moins une des revendications précédentes, sachant que le substrat est transporté dans la chambre de traitement en étant disposé sur un support,
**caractérisé en ce**
**que** le substrat disposé sur ledit support est exposé dans la chambre de prétraitement sous une température T avec 250 °C ≤ T ≤ 800 °C, notamment 400 °C ≤ T ≤ 800 °C, au gaz oxydant, tel l'air, pendant une durée t avec t > 1 s, de préférence t > 2 s, notamment 2 s ≤ t ≤ 60 s.

6. Procédé selon au moins la revendication 1,
**caractérisé en ce**
**qu'**est utilisé comme gaz oxydant au moins un gaz du groupe oxygène, oxyde nitreux, ozone ou des mélanges de ces gaz.

7. Procédé selon au moins la revendication 1,
**caractérisé en ce**
**qu'**est utilisé comme composants de la solution alcaline au moins un composant du groupe NaOH, KOH, hydroxyde de tétraalkylammonium, hydroxyde de tétraméthylammonium, et/ou de l'acide méthanesulfonique pour la solution acide.

8. Procédé selon au moins la revendication 1,
**caractérisé en ce**
**qu'**est utilisé comme agent oxydant un agent du groupe percarbonates, perborates, peroxomonosulfates, peroxodisulfates, hypochlorite.

9. Procédé selon au moins la revendication 1,
**caractérisé en ce**
**qu'**est ajouté à l'agent oxydant au moins un autre composant du groupe des stabilisateurs, agents complexants, agents tensioactifs.

10. Procédé selon au moins une des revendications précédentes,
**caractérisé en ce**
**que** le substrat dans la chambre de prétraitement est exposé à une température T avec T ≥ 300 °C, de préférence T ≥ 350 °C, notamment T ≥ 400 °C.

11. Procédé selon au moins une des revendications précédentes,
**caractérisé en ce**
**que** la couche appliquée sur la couche d'oxyde de silicium est formée en contenant de l'hydrogène.

12. Procédé selon au moins une des revendications précédentes,
**caractérisé en ce**
**que** la couche appliquée sur la couche d'oxyde de silicium est formée sous forme d'au moins une couche, telle une couche de nitrure de silicium, une couche d'oxynitrure de silicium, une couche d'oxyde de silicium, une couche d'oxyde d'aluminium, une couche de nitrure d'aluminium, une couche d'oxyde de titane, notamment sous forme de système de couches comprenant au moins deux couches.
